# EUROPEAN PATENT SPECIFICATION

(11) **EP 1 694 506 B1**
(45) Date of publication and mention of the grant of the patent: **29.10.2008**
(21) Application number: 04801484.9
(22) Date of filing: 07.12.2004
(51) Int. Cl.: B41F 27/04

(54) **METHOD AND APPARATUS FOR PRINTING A PATTERNED LAYER ON A FLAT SUBSTRATE WITH A FLAT-TYPE-BED**
VERFAHREN UND VORRICHTUNG ZUM DRUCKEN EINER GEMUSTERTEN SCHICHT AUF EINEN FLACHEN TRÄGER MIT EINEM FLACH-BETT
METHODE ET APPAREIL D'IMPRESSION D'UNE COUCHE PORTANT UN MOTIF SUR UN SUBSTRAT PLAT AU MOYEN D'UN MARBRE A PLAT

(30) Priority: 09.12.2003 GB 0328459
(43) Date of publication of application: 30.08.2006
(73) Proprietor: Koninklijke Philips Electronics N.V., 5621 BA Eindhoven (NL)
(72) Inventor: CHAPMAN, Jeffrey A., Philips IP & Standards, Redhill, Surrey RH1 5HA (GB)
(74) Representative: Damen, Daniel Martijn
(86) International application number: PCT/IB2004/052691
(87) International publication number: WO 2005/056294

(56) References cited:
- US-A- 2 609 749
- US-A- 5 272 980
- US-A- 5 352 634
- US-A- 5 367 953
- US-A1- 2001 026 894

## Description

The invention relates to a method of printing a patterned layer onto a substrate, to a printing machine bed, and to a printing machine.

TFTs are widely used in liquid crystal and other flat panel displays, including active matrix LCDs (AMLCDs), to control or sense the state of each pixel in the display.

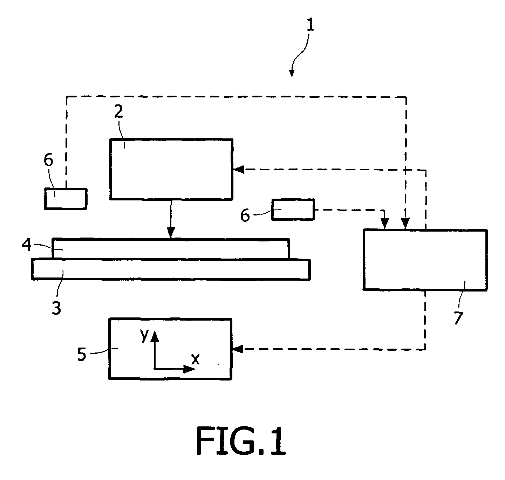

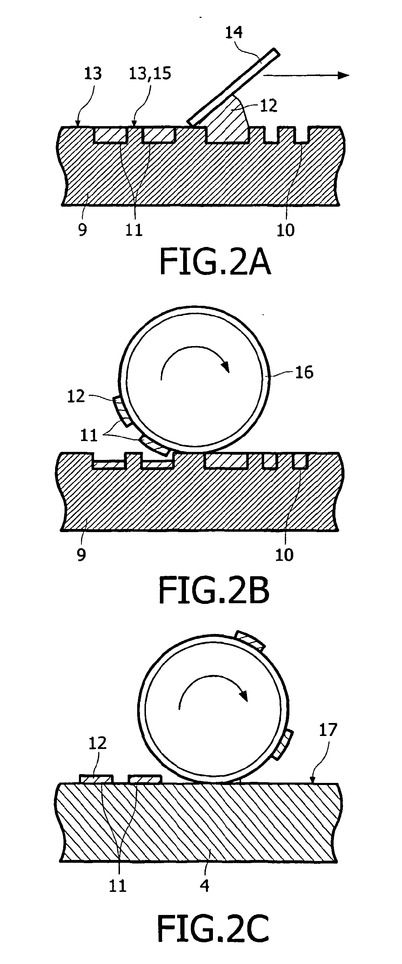

A TFT structure is formed by successively providing layers of different materials. The layers may be patterned using photolithography. Alternatively, the layers may be patterned using a printed photoresist layer or the patterned layers themselves (or precursor materials thereof) may be directly printed onto the substrate. One suitable printing technique is now described with reference to Figures 1 and 2.

Referring to Figure 1, apparatus 1 for fabricating a device, such as a thin-film transistor, includes printing means 2, for example a gravure offset printer, means 3 for supporting a layer structure 4, in this example a rigid stage, means 5 for moving the printing means 2 relative to the layer structure 4, in this example electrical motors, means 6 for detecting position of the printing means 1 relative to the layer structure 4, in this example an optical microscope and digital camera, and means 7 for controlling the printing means 2 and moving means 5, in this example a programmed general-purpose computer. Etching is carried out downstream.

The printing means 2 is arranged to print a number of patterned layers in succession. An offset printing process is used, and printing of each layer generally comprises three steps, as follows.

Referring to Figure 2(a), a first step comprises inking. A pattern carrying means 9, in this example a cliché in the form of a glass plate, includes a plurality of grooves 10 which are arranged to define a pattern 11. Ink 12 is applied to the surface 13 of the image carrying means 9 and a filling means 14, which is often referred to as a doctor blade and which in this example is a metal blade, is passed over the surface 13 of the pattern carrying means 9 so as to fill the grooves 10 with ink 12, and to clear ink 12 from regions 15 between the grooves 10.

Referring to Figure 2(b), a second step comprises transferring the pattern 11 from the pattern carrying means 9. Pattern transferring means 16, for example in the form of a large diameter cylindrical blanket comprising a polymer fixed around a metal roller, is applied to the surface 13 of the pattern carrying means 9 by rolling, so as to pick up some of the ink 12 in each groove 10. Typically, about half the ink is picked up. The pattern 11 is preserved on the pattern transferring means 16.

Referring to Figure 2(c), a third step comprises printing the pattern 11. The pattern transferring means 16 carrying ink 12 is applied, for example by rolling, to a surface 17 of the layer structure 4. Thus, ink 12 is transferred from the pattern transferring means 16 onto the surface 17 of the layer structure 4.

US-A-5,352,634 describes the printing of active matrix arrays.

US-A-6,576,378 describes the use of alignment marks in the manufacture of a large scale LCD device. US-A-5,407,763 discloses the use of shaped marks to allow alignment to be detected.

US-A-6,583,854 and US-A-6,146,796 disclose techniques for interfitting mask patterns on larger display devices.

US 5,367,953 discloses a roller offset printing method using image sensors for correcting the positions of the master plate and work plate.

The layer structure 4 used when manufacturing active matrix LCD screens for television sets or computing device displays, for example, is known as mother glass. It is usual for plural discrete arrays to be included on a single mother glass 4. In the field of AMLCD displays, the discrete arrays when finished can be termed 'displays', since each relates to one display. Conventionally a cliché used in printing on a mother glass is at least as large as the mother glass, and has the same number of arrays formed on it. For example, a cliché (and a mother glass) can be formed with sixteen arrays thereon. The clichés could be produced using a large sheet of glass.

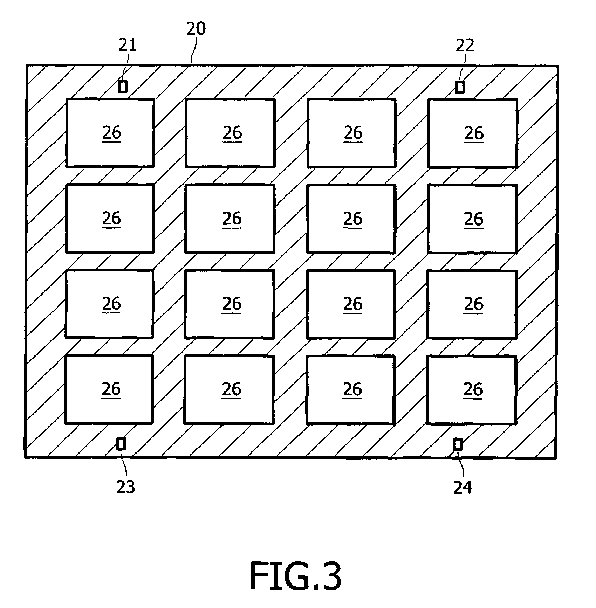

There is a trend for mother glass size to increase. Mother glass of more than one metre square is known, which can be populated with tens of discrete arrays. However, as mother glass size increases, the extent of glass distortion increases, which has a negative effect on the design process. In particular, misalignment of layers in an AMLCD can degrade performance and optical aperture, and this becomes more difficult to avoid as mother glass size increases. The effects are worse with printing of layers than they are with S some other layer patterning techniques, although printing has significant cost advantages associated with it. To aid alignment of the layers deposited onto a mother glass, a number of alignment marks tend to be provided both on the mother glass 4 and on the cliché 9. A typical arrangement is illustrated in Figure 3. Here a mother glass or cliché 20 (they both have the same general layout) is shown with first to fourth alignment marks 21 to 24 and sixteen arrays 26, arranged four deep by four wide.

The position of alignment marks on the cliché 9 and on the mother glass 4 are detected, and the position of the cliché and mother glass relative to each other is adjusted as necessary electronically for the best match before printing is and then the pattern is transferred using the blanket 16. This helps to ensure that the arrays 26 are printed at the correct positions.

According to a first aspect of the invention, there is provided a method of printing a patterned layer onto a print substrate, the method comprising (a) detecting the alignment of each of plural areas on the print substrate or on a second substrate, (b) transferring material from clichés supported on the subbeds onto a common carrier, and (c) transferring the material from the common carrier onto the print substrate. The method further comprises individually positioning subbeds of a printing machine in accordance with the detected alignment before the material transfer.

The method can additionally comprise detecting the alignment of the clichés supported on the subbeds, and positioning the subbeds also in accordance with the detected alignment of the clichés. This can allow for the position of the clichés on the subbeds to be compensated for.

In an embodiment, a method is used to print a layer of ink onto a mother glass substrate, although the invention has broader application than this.

The positioning step can comprise adjusting the position and/or orientation of the subbeds.

A second aspect of the invention provides a printing machine comprising (a) a printing machine bed comprising an array of two or more subbeds, (b) an alignment mechanism for each subbed such that each subbed is individually alignable in a common plan, and (c) a controller operable to control alignment of the subbeds using the alignment mechanisms

The printing machine bed can for example comprise an array of four or more individually alignable subbeds.

The printing machine bed preferably is usable in the printing of the components for liquid crystal displays, for example, active matrices.

The aligning of the subbeds can comprise adjusting the position and/or orientation of the subbeds.

Embodiments of the present invention will now be described, by way of example only, with reference to the accompanying drawings in which:
Figure 1 is a schematic diagram of apparatus for fabricating a device using gravure offset printing;
Figures 2(a), 2(b) and 2(c) illustrate steps in a process implemented by the Figure 1 printing apparatus;
Figure 3 illustrates a typical cliché or mother glass layout;
Figure 4 is a flow diagram showing a method of forming a patterned layer according to one aspect of the invention;
Figure 5 schematically illustrates a printer used in the Figure 4 method and according to another aspect of the invention; and
Figure 6 is a flow diagram showing a method of forming a patterned layer according to an aspect of the invention.

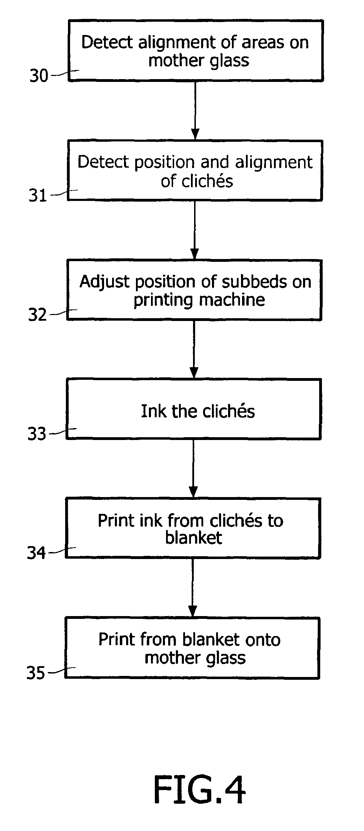

A method of printing a patterned layer according to one aspect of the invention and utilising a printer bed according to another aspect will now be described with reference to Figure 4. Here the method begins at step 30 by detecting the position and alignment of arrays on a mother glass. By way of example, a mother glass 4 (see Figure 2(c)) is notionally divided into four areas, each area containing four arrays. Each of the four areas has alignment marks associated with it, so that the positions and alignment of each area, and thus the arrays within it, can be detected automatically. However, the mother glass 4 is retained as a single piece. The position and alignment detection can occur in any suitable manner.

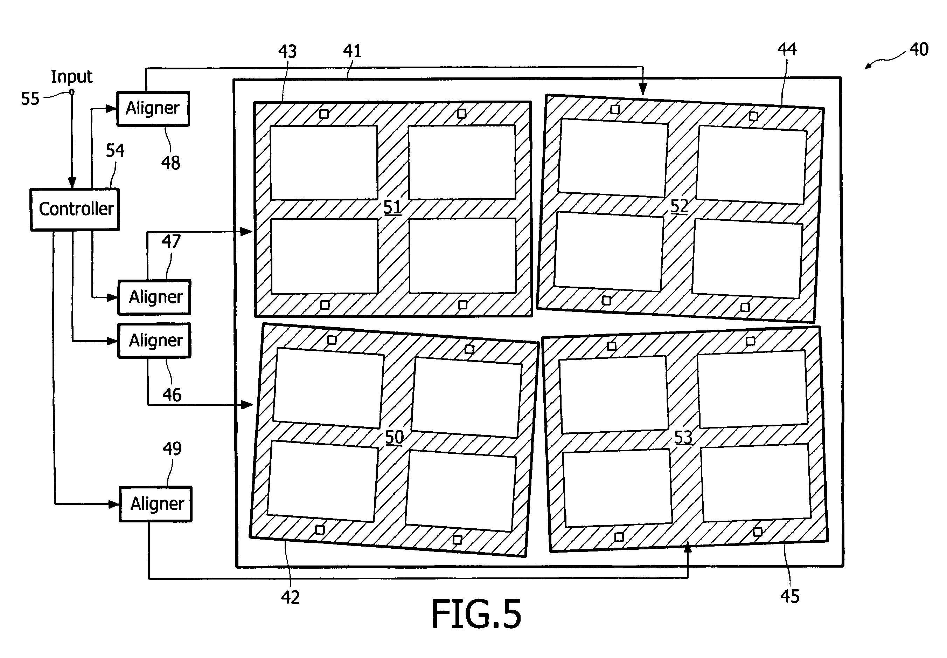

At step 31, the position and alignment of clichés supported on subbeds on the bed of a printing machine (described below with reference to Figure 5) are detected electronically using alignment marks thereon. At step 32, the positions of the subbeds are adjusted according to the detected alignment and position of the areas on the mother glass and the positions and alignment of the clichés. The clichés are then inked at step 33. Alternatively, steps 32 and 33 could be reversed, i.e. the clichés could be inked before the subbed positions are adjusted. At step 34 ink is transferred from the clichés, supported on the printer subbeds, onto a blanket 16 (as in Figure 2(b)). Finally, at step 35, the material on the blanket 16 is transferred onto the mother glass (as in Figure 2(c)).

A printing machine 40 including a printing bed 41 according to one aspect of the invention is shown in Figure 5. The machine 40 is illustrated schematically, and it will be appreciated that it includes numerous unshown components. On the printing bed 41 are arranged first to fourth subbeds 42 to 45. Each subbed 42 to 45 is associated with a respective mechanical alignment mechanism shown at 46 to 49. Four clichés 50 to 53 are supported on the printing bed 41, one cliché on each subbed 42-45. Each cliché 50 to 53 has its operative face uppermost. The clichés 50 to 53 are illustrated in plan view. The uppermost surfaces of the clichés 50 to 53 are formed in the same plane, allowing the blanket 16 (shown in Figure 2) to collect ink 12 (or other material) from all the clichés as it is passed over the uppermost surface, for subsequent printing onto the mother glass 4. The blanket 16 is wider than twice the relevant dimension of the clichés 50 to 53, assuming the clichés are all the same size.

The aligners 46 to 49 are each connected to a controller 54, which in turn is connected to receive alignment signals at an input 55. These alignment signals are provided by a controller (not shown) on the basis of the positions of alignment marks on the mother glass 4. The alignment signals fed to the controller 54 via the input 55 identify the alignment required of the subbeds 42 to 45. The controller 54 uses the alignment signals to provide suitable control signals to the aligners 46 to 49. The subbeds 42 to 45 are aligned by the aligners 46 to 49 in accordance with the required alignments. In this way, the clichés 50 to 53 become aligned with the arrays on the mother glass 4. This allows material 12 transferred from the clichés to the mother glass 4 via the blanket 16 to be more closely aligned with its desired alignment than is possible without individually alignable subbeds 42 to 45.

The printing machine 40 accordingly is able to compensate to a degree for distortions in the mother glass 4. The amount of compensation achievable depends on the number of subbeds 42 to 45 on the printing bed 41, which number determines the number of clichés 50 to 53. The printing bed 41 might be produced to have a number of subbeds equal to the number of arrays 26 on the mother glass 4.

The amount by which the subbeds 42 to 45 are required to be moved is dependent on the possible amount of distortion of the mother glass. With a mother glass of approximately one meter square and assuming that normal operating conditions apply, it may be that each subbed may be movable up to 30 microns in any direction. Of course, the alignment of the subbeds typically will involve their translation in x and y directions and also their rotation about an axis perpendicular to the plane of the uppermost surface of the clichés 50 to 53. To allow movement to occur whilst allowing proper alignment, the clichés 50 to 53 are slightly smaller than the size of the corresponding area of the mother glass 4. The arrangement illustrated in Figure 5 is an exaggerated example of how the clichés 50 to 53 might appear after alignment and before the blanket 16 is passed over them. Alignment is carried out in respect of each mother glass 4, since different mother glasses are likely to distort differently even under the same conditions.

This invention has utility in that some distortions in the mother glass can be compensated for. Also, the clichés are significantly smaller than would otherwise be required, so can be significantly cheaper to produce.

Although in the above the printing process has been described in relation to a layer of ink, it will be appreciated that the process, and the apparatus, can be used in relation to any suitable material. For example, the process and apparatus could be used to print a layer of precursor, silver particles in a binder to cite a non-limiting example, or any other substance, composition or mixture which is required to be printed.

Also, the invention is usable to print onto mother glass or any other substrate on which a printed layer is required. For example, an LCD cell comprises an active plate and a passive plate with a liquid crystal material sandwiched between them. The active plate is formed from the mother glass making process which is partially described above. The passive plate is formed with features including a colour filter and a black grid. The black grid blocks any unmodulated light. Passive plates are not temperature cycled as much as active plates, so they tend to experience less distortion. The features on the passive plate are positioned so that after coupling they are aligned with the appropriate feature on the active plate. Coupling of active and passive plates to make displays often takes place before the mother glass plates are cut into individual cells. In this case, care has to be taken that the match is correct for all arrays to be made from the plates.

A method of making passive plates is now described with reference to Figures 2, 5 and 6.

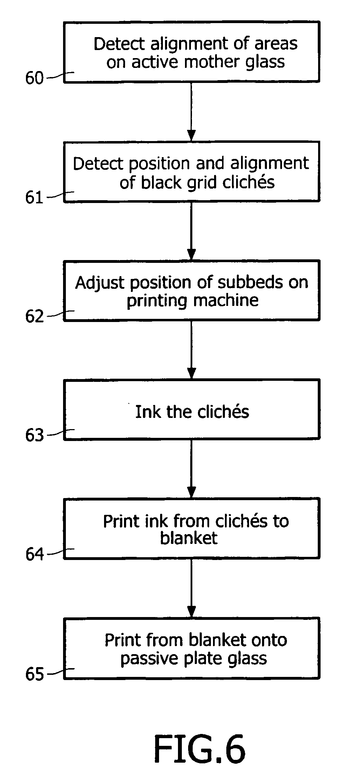

In Figure 6, the process begins at step 60 by electronically detecting alignment of the areas (each containing one or more arrays) on a finished active mother glass. At step 61, the position and alignment of passive plate black grid clichés 50 to 53 supported on subbeds 42 to 45 on the bed 41 of the printing machine 40 (see Figure 5) are detected electronically using alignment marks thereon. At step 62, the positions of the subbeds are adjusted according to the detected alignment and position of the areas on the finished active mother glass and the positions and alignment of the clichés. The clichés are then inked at step 63. Alternatively, steps 62 and 63 could be reversed, i.e. the clichés could be inked before the subbed positions are adjusted. At step 64 ink is transferred from the clichés 50 to 53, supported on the printer subbeds 42 to 45, onto a blanket 16 (see Figure 2(b)). Finally, at step 65, the material on the blanket 16 is transferred onto the passive plate glass (as in Figure 2(c)). This provides a passive plate glass with black grid inking aligned with the arrays on the mother glass with which the passive plate is to be used. The same process can be used to apply colour filter to the passive plate glass.

This process allows a passive plate to be made to match the specific active plate with which it is to be coupled, and to compensate for the distortions within that plate.

## Claims

1. A method of printing a patterned layer onto a print substrate (4), the method comprising:
- detecting (30; 60) the alignment of each of plural areas on the print substrate (4) or on a second substrate;
- transferring (34) material from clichés (50-53) supported on the subbeds onto a common carrier (16); and
- transferring (35;65) the material from the common carrier (16) onto the print substrate (4),
**characterised in that** the method further comprises individually positioning (32;61) subbeds (42-45) of a printing machine (40) in accordance with the detected alignment before the material transfer.

2. A method as claimed in claim 1, comprising detecting (31; 61) the alignment of the clichés (50-53) supported on the subbeds (42-45), and positioning the subbeds (42-45) also in accordance with the detected alignment of the clichés (50-53).

3. A printing machine (40) comprising a printing machine bed (41) comprising an array of two or more subbeds (42-45), **characterised in that** the machine (40) further comprises an alignment mechanism (46-49) for each subbed (42-45) such that each subbed (42-45) is individually alignable in a common plane, and a controller (54) operable to control alignment of the subbeds (42-45) using the alignment mechanisms (46-49).

## Patentansprüche

1. Verfahren zum Drucken einer strukturierten Schicht auf einem Drucksubstrat, wobei das Verfahren die folgenden Schritte umfasst:
- Detektieren (30; 60) der Ausrichtung jeder von mehreren Flächen auf dem Drucksubstrat (4) oder auf einem zweiten Substrat,
- Übertragen (34) von Material von auf den Teilbetten getragenen Klischees (50-53) auf einen gemeinsamen Träger (16) sowie
- Übertragen (35; 65) des Materials von dem gemeinsamen Träger (16) auf das Drucksubstrat (4),
**dadurch gekennzeichnet, dass** das Verfahren weiterhin individuelles Positionieren (32; 61) von Teilbetten (42-45) einer Druckmaschine (40) gemäß der detektierten Ausrichtung vor der Materialübertragung umfasst.

2. Verfahren nach Anspruch 1, welches das Detektieren (31; 61) der Ausrichtung der auf den Teilbetten (42-45) getragenen Klischees (50-53) sowie das Positionieren der Teilbetten (42-45) ebenfalls gemäß der detektierten Ausrichtung der Klischees (50-53) umfasst.

3. Druckmaschine (40) mit einem Druckmaschinenbett (41) mit einer Anordnung von zwei oder mehreren Teilbetten (42-45), **dadurch gekennzeichnet, dass** die Maschine (40) weiterhin einen Ausrichtungsmechanismus (46-49) für jedes Teilbett (42-45) umfasst, so dass jedes Teilbett (42-45) in einer gemeinsamen Ebene einzeln ausrichtbar ist, sowie eine Steuereinrichtung (54) aufweist, welche so betätigbar ist, dass sie die Ausrichtung der Teilbetten (42-45) unter Verwendung des Ausrichtungsmechanismus (46-49) steu ert.

## Revendications

1. Procédé d'impression d'une couche portant un motif sur un substrat d'impression (4), le procédé comprenant :
- la détection (30; 60) de l'alignement de chacune de plusieurs zones sur le substrat d'impression (4) ou sur un deuxième substrat;
- le transfert (34) de matériau venant de clichés (50-53) supportés par les sous-socles sur un support commun (16) ; et
- le transfert (35; 65) du matériau venant du support commun (16) sur le substrat d'impression (4),
**caractérisé en ce que** le procédé comprend en outre le placement individuel (32; 61) de sous-socles (42-45) d'une machine à imprimer (40) selon l'alignement détecté avant le transfert du matériau.

2. Procédé suivant la revendication 1, comprenant la détection (31; 61) de l'alignement des clichés (50-53) supportés par les sous-socles (42-45), et le placement des sous-socles (42-45) également selon l'alignement détecté des clichés (50-53).

3. Machine à imprimer (40) comprenant un socle de machine à imprimer (41) comprenant un groupement de deux ou plus de deux sous-socles (42-45), **caractérisée en ce que** la machine (40) comprend en outre un mécanisme d'alignement (46-49) pour chaque sous-socle (42-45) de sorte que chaque sous-socle (42-45) peut être individuellement aligné dans un plan commun, et un dispositif de commande (54) servant à commander l'alignement des sous-socles (42-45) à l'aide des mécanismes d'alignement (46-49).
